Europäisches Patentamt

European Patent Office

Office européen des brevets

(19)

(11) Publication number: **0 074 168**
**B1**

(12) # EUROPEAN PATENT SPECIFICATION

(45) Date of publication of patent specification: **08.01.86**

(21) Application number: **82303929.2**

(22) Date of filing: **23.07.82**

(51) Int. Cl.⁴: **H 01 L 21/92, H 01 R 9/16**

(54) Device and method for packaging electronic devices.

(30) Priority: **24.07.81 JP 115901/81**

(43) Date of publication of application:
**16.03.83 Bulletin 83/11**

(45) Publication of the grant of the patent:
**08.01.86 Bulletin 86/02**

(84) Designated Contracting States:
**DE FR GB**

(56) References cited:
**DD-A- 96 608**
**DE-A-2 306 288**
**DE-B-2 159 530**
**GB-A-1 206 759**
**US-A-4 246 697**

**PATENT ABSTRACTS OF JAPAN, unexamined
applications, Section E, vol. 1, no. 58, June 6,
1977, THE PATENT OFFICE JAPANESE
GOVERNMENT, page 40 E 77**

(73) Proprietor: **FUJITSU LIMITED**
**1015, Kamikodanaka Nakahara-ku**
**Kawasaki-shi Kanagawa 211 (JP)**

(72) Inventor: **Shimizu, Shokichi**
**37-2, Okamoto**
**Kamakura-shi Kanagawa 247 (JP)**
Inventor: **Aoki, Hideji**
**Fujinodai-danchi 1-47-102 3486, Honmachida**
**Machida-shi Tokyo 194 (JP)**
Inventor: **Kida, Susumu**
**3-16-1-409, Kaminoge**
**Setagaya-ku Tokyo 158 (JP)**
Inventor: **Kanazawa, Yuki**
**2-3-308, Nagataminamidai Minami-ku**
**Yokohama-shi Kanagawa 232 (JP)**

(74) Representative: **Fane, Christopher Robin King
et al
HASELTINE LAKE & CO. Hazlitt House
28 Southampton Buildings Chancery Lane
London, WC2A 1AT (GB)**

Courier Press, Leamington Spa, England.

## Description

The present invention relates to the packaging of electronic devices.

Cer-dip type ceramic packages are widely used for electronic devices because of their lower production costs compared to multilayered ceramic type packages.

The outerleads of cer-dip type ceramic packages are usually electroplated with tin or an alloy of tin and lead after sealing the package by means of fused glass. Such cer-dip type ceramic packages can be successfully assembled on a substrate by soldering. The outerleads, however, are liable to incompletely contact gold-electroplated sockets due to fretting corrosion. To prevent this, gold may be electroplated on the outerleads of the packages.

Gold-electroplating after glass-sealing, however, can result in several disadvantages. The sealing glass may be chemically etched by the gold-electroplating bath. The surface of etched glass is chemically active and tends to be electroplated, even partly, with gold, which can lead to an electric short-circuit between the outerleads. The glass dissolved by the etching, further, contaminates the electroplating bath and shortens its service life.

Thus it is desirable to provide a means whereby there can be produced a package for an electronic device having a final, working contact layer on the outerleads which layer is capable of completely contacting gold-electroplated sockets and has been electroplated onto the outerleads without affecting sealing glass used in the packaging process.

It has been proposed in DE—OS 23 06 288 to plate at least the contacts of a lead frame with gold before connecting the frame to the electronic device and sealing the package.

According to the present invention a lead frame for packaging an electronic device has outerlead parts plated with an underlayer of metal selected from the platinum group of metals and a working contact layer plated thereon.

According to another aspect of the invention a package enclosing an electronic device is produced by the steps of

electroplating outerlead parts of a lead frame, separately from any outer housing structure component of the package, so as to provide an underlayer of metal selected from the platinum group of metals and a working contact layer thereon;

fixing the electronic device in its desired position relative to the said lead frame and providing electrical connections between the device and respective innerlead parts of the frame;

sealing a housing structure around the device so that it is enclosed within that structure but so that outerlead parts covered by the working contact layer are left projecting from that structure.

The process of the invention dispenses with the wet process of electroplating, otherwise required after sealing the enclosure. This can improve the reliability and productivity of a package for an electronic device.

The working contact layer is advantageously of gold or silver, and the use of an underplate electroplated with platinum group metal enables the thickness of a final layer of gold or silver to be reduced to about one third of the thickness required in the case where the final layer is only gold or silver.

Conveniently, the final gold or silver layer is electroplated only on a portion of the outerlead area, in the case where the underplate layer extends as far as within the fused glass. Such an underplate of metal selected from the platinum group metals can prevent oxidation of the lead frame.

The invention will now be described, by way of example, with reference to the accompanying drawings in which

Figure 1 is a perspective view of a lead frame, and

Figure 2 is a sectional view of a cer-dip type ceramic package containing an electronic device, made in accordance with an embodiment of the present invention.

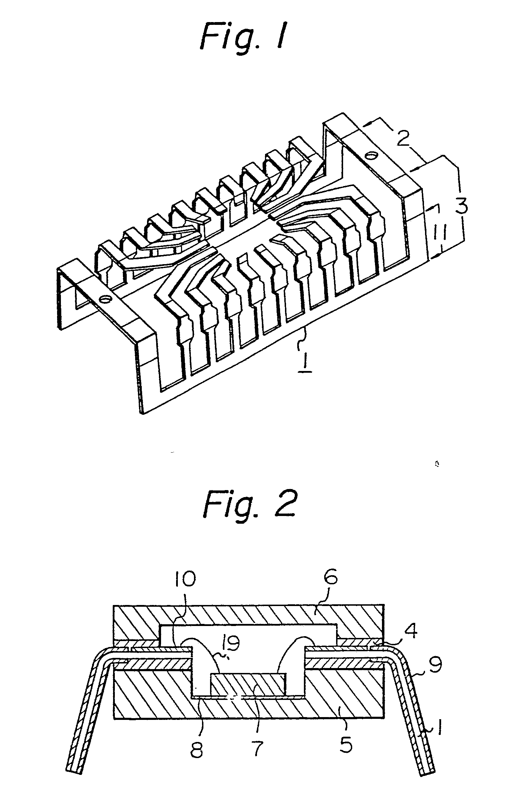

As shown in Figure 1, lead frame 1 comprises innerlead area 2 and outerlead area 3. Lead frame 1 is commonly made of an alloy of iron and nickel. Referring to Figure 2, lead frame 1 is fixed in a package by embedding its innerlead area (2) in fused glass 4, which seals ceramic substrate 5 to a ceramic lid 6 of the package. An electronic device 7 is bonded to ceramic substrate 5 via metallized layer 8, e.g. of gold. Device 7 is connected by means of aluminum wire 19 with innerlead area 2 clad with aluminium 10. Outerlead area 3 extends out of the fused glass 4.

Outerlead area 3 (Figure 1) is electroplated with gold of 3 to 5 µm thickness as a final, working contact layer 9 on a layer of nickel of 1.0 to 3.0 µm thickness. This final layer 9 of gold can prevent thermal diffusion of base metal during glass sealing of the housing structure (4, 5, 6) of the package, so that the gold does not exhibit a change in colour.

The thickness of gold of the final layer 9 can be further reduced as described in the following example. Outerlead area 3 is sequentially electroplated with nickel of 0.2 to 1.0 µm thickness, with gold of 0.1 to 0.2 µm thickness, with rhodium of 0.2 to 0.5 µm thickness, and finally with gold of 0.5 to 1.5 µm thickness. The underlayer of rhodium acts as a barrier against thermal diffusion of the base metal, so that the relatively thin final layer of gold does not exhibit a change in colour after packaging.

In addition, a gold-electroplated layer of excellent appearance may be obtained by preventing permeation of the electroplating liquid through the gap between the lead frame and the masking jig. This may be done by depressing the portion of the lead frame to be masked with the jig.

As another example, all the layers in the above-described example except the final layer 9 are electroplated over the whole of the outerlead area 3. The final layer 9 of gold is applied so as to cover only an end portion 11 (Figure 1), which is about one half of the entire outerlead area 3.

Keeping down the thickness and area of the final layer of the electroplated gold in this way assists in keeping down the production costs of a lead frame and, consequently, of a package for an electronic device having leads produced of such a lead frame.

### Claims

1. A lead frame for use in packaging an electronic device but before being fixed to any housing structure to be used for such packaging, having a plating on the outerlead parts of the frame, characterized in that the plating comprises an underlayer of metal selected from the platinum group of metals and a working contact layer thereon.

2. A method of producing a package enclosing an electronic device, which method comprises in sequence the steps of:

electroplating outerlead parts (3) of a lead frame (1), separately from any outer housing structure component of the said package, so as to provide a working contact layer (9) thereon;

fixing the electronic device (7) in its desired position relative to the said lead frame and providing electrical connections (19) between the device and respective innerlead parts (2) of the frame; and

sealing a housing structure (5, 6) around the device so that it is enclosed within that structure but so that outerlead parts covered by the said working contact layer are left projecting from that structure, characterized in that the electroplating step comprises plating an underlayer of metal selected from the platinum group of metals and then plating a working contact layer thereon.

3. A method as claimed in claim 2, wherein the housing structure is sealed with fused glass.

4. A method as claimed in claim 2 or 3, wherein portions of the lead frame that are covered by the layer produced by the electroplating are sealed within the said housing structure.

5. A lead frame as claimed in claim 1, or a method as claimed in claim 2, 3 or 4, wherein the working contact layer is made of gold or silver.

6. A lead frame or a method, as claimed in claim 5, wherein the platinum group metal is rhodium.

7. A method according to claim 2, 3, 4, 5 or 6 wherein portions of the lead frame that are covered with said underlayer are sealed within the said housing structure.

8. A package for an electronic device, comprising outerleads (3) having an electroplated final layer of gold or silver and innerleads (2) embedded in glass, said final layer on the outerleads extending within the glass, characterized in that said final layer has an electroplated underplate of metal selected from the platinum group metals, said underplate extending within the glass.

9. A package as claimed in claim 8, wherein said metal is rhodium.

10. A package as claimed in claim 8 or 9, wherein said final layer of gold or silver is electroplated only on an end portion of the outerleads.

### Revendications

1. Cadre de montage destiné à être utilisé dans la mise sous boîtier d'un dispositif électronique, lequel cadre de montage, avant d'être fixé à une quelconque structure protectrice à utiliser dans cette mise sous boîtier, reçoit un placage sur les parties des connexions extérieures du cadre, caractérisé en ce que le placage comprend une sous-couche d'un métal choisi parmi les métaux du groupe de platine et une couche de contact de travail située au-dessus de celle-ci.

2. Procédé de production d'un boîtier contenant un dispositif électronique, le procédé comprenant les opérations consécutives suivantes:

effectuer le placage électrolytique de parties (3) des conducteurs extérieurs d'un cadre de montage (1), séparément de tout élément d'une structure protectrice extérieure dudit boîtier, de façon à produire sur celles-ci une couche de contact de travail (9);

fixer le dispositif électronique (7) dans sa position voulue par rapport audit cadre de montage et réaliser des connexions électriques (19) entre le dispositif et des parties respectives (2) des conducteurs intérieurs du cadre; et

sceller une structure protectrice (5, 6) autour du dispositif de façon que celui-ci soit enfermé à l'intérieur de cette structure, mais qu'il subsiste des parties des conducteurs extérieurs recouvertes par ladite couche de contact de travail qui fassent saillie de cette structure, caractérisé en ce que l'opération de placage électrolytique consiste à faire déposer une sous-couche d'un métal choisi parmi les métaux du groupe du platine, puis à faire déposer sur celle-ci une couche de contact de travail.

3. Procédé selon la revendication 2, où on scelle la structure protectrice à l'aide de verre fondu.

4. Procédé selon la revendication 2 ou 3, où on scelle à l'intérieur de ladite structure protectrice des parties du cadre de montage qui sont recouvertes par la couche produite par le placage électrolytique.

5. Cadre de montage selon la revendication 1, ou procédé selon la revendication 2, 3 ou 4, où la couche de contact de travail est faite d'or ou d'argent.

6. Cadre de montage ou procédé selon la revendication 5, où le métal du groupe du platine est le rhodium.

7. Procédé selon la revendication 2, 3, 4, 5 ou 6, où on scelle à l'intérieur de ladite structure protectrice des parties du cadre de montage qui sont recouvertes à l'aide de ladite sous-couche.

8. Boîtier pour dispositif électronique, qui comprend des conducteurs extérieurs (3) possédant une couche finale d'or ou d'argent formée par électrodéposition et des conducteurs intérieurs (2) noyés dans du verre, ladite couche finale qui se trouve sur les conducteurs extérieurs s'étendant jusqu'à l'intérieur du verre, caractérisé en ce que ladite couche finale possède une sous-couche d'un métal choisi parmi les métaux du groupe du platine qui est formée par électrodéposition, ladite sous-couche s'étendant jusqu'à l'intérieur du verre.

9. Boîtier selon la revendication 8, où ledit métal est le rhodium.

10. Boîtier selon la revendication 8 ou 9, où ladite couche finale d'or ou d'argent n'est formée, par électrodéposition, que sur une partie terminale des conducteurs extérieurs.

## Patentansprüche

1. Leitungsrahmen zur Verwendung beim Verpacken einer elektronischen Vorrichtung, jedoch bevor er mit irgendeiner Gehäusekonstruktion verbunden wird, die für eine solche Verpackung verwendet werden soll, mit einer Plattierung auf den Außenleitungsteilen des Rahmens, dadurch gekennzeichnet, daß die Plattierung eine Unterschicht aus Metall, ausgewählt aus der Platingruppe von Metallen, und eine Arbeitskontaktschicht darauf umfaßt.

2. Verfahren zur Herstellung einer Verpackung, welche eine elektronische Vorrichtung enthält, welches die folgenden Schritte umfaßt:

Elektroplattierung der Außenleitungsteile (3) eines Leitungsrahmens (1), separat von irgendeiner äußeren Gehäusekonstruktionskomponente der genannten Verpackung, um so eine Arbeitskontaktschicht (9) darauf vorzusehen;

Fixierung der elektronischen Vorrichtung (7) in ihrer gewünschten Position relativ zu dem genannten Leitungsrahmen und Bildung elektrischer Verbindungen (19) zwiwchen der Vorrichtung und den jeweiligen Innenleitungsabschnitten (2) des Rahmens; und

Versiegelung einer Gehäusekonstruktion (5, 6) um die Vorrichtung so, daß sie innerhalb der Konstruktion eingeschlossen ist, jedoch so, daß die äußeren Leitungsabschnitte, die durch die genannte Arbeitskontaktschicht bedeckt sind, von der Konstruktion vorstehend gelassen werden, dadurch gekennzeichnet, daß der Schritt des Elektroplattierens die Plattierung einer Unterschicht aus Metall, ausgewählt aus der Platingruppe von Metallen, und anschließend die Plattierung der Arbeitskontaktschicht auf dieser umfaßt.

3. Verfahren nach Anspruch 2, bei welchem die Gehäusekonstruktion mit geschmolzenem Glas versiegelt wird.

4. Verfahren nach Anspruch 2 oder 3, bei welchem Abschnitte des Leitungsrahmens, die durch die Schicht bedeckt sind, welche durch Elektroplattierung hergestellt worden ist, innerhalb der Gehäusekonstruktion versiegelt werden.

5. Leitungsrahmen nach Anspruch 1 oder Verfahren nach Anspruch 2, 3 oder 4, bei welchem die Arbeitskontaktschicht aus Gold oder Silber besteht.

6. Leitungsrahmen oder Verfahren, nach Anspruch 5, bei welchem das Platingruppenmetall Rhodium ist.

7. Verfahren nach Anspruch 2, 3, 4, 5 oder 6, bei welchem Abschnitte des Leitungsrahmens, die mit der genannten Unterschicht bedeckt sind, innerhalb der genannten Gehäusekonstruktion versiegelt werden.

8. Verpackung für eine elektronische Vorrichtung, mit Außenleitungen (3), die eine elektroplattierte Endschicht aus Gold oder Silber haben, und mit Innenleitungen (2), die in Glas eingebettet sind, wobei die genannte Endschicht auf den Außenleitungen sich innerhalb des Glases erstreckt, dadurch gekennzeichnet, daß die genannte Endschicht eine. elektroplattierte Unterplatte aus Metall, ausgewählt aus den Platingruppenmetallen, hat, welche Unterplatte sich innerhalb des Glases erstreckt.

9. Verpackung nach Anspruch 8, bei welcher das genannte Metall Rhodium ist.

10. Verpackung nach Anspruch 8 oder 9, bei welcher die genannte Endschicht aus Gold oder Silber nur auf einem Endabschnitt der Außenleitungen elektroplattiert ist.

# Fig. 1

# Fig. 2